# EUROPEAN PATENT APPLICATION

(11) **EP 3 007 209 A1**
(43) Date of publication of application: **13.04.2016**
(21) Application number: 14808288.6
(22) Date of filing: 26.05.2014
(51) Int. Cl.: H01L 21/205, C30B 25/20, C30B 29/36, H01L 21/304

(54) **METHOD FOR MANUFACTURING SIC SINGLE-CRYSTAL SUBSTRATE FOR EPITAXIAL SIC WAFER, AND SIC SINGLE-CRYSTAL SUBSTRATE FOR EPITAXIAL SIC WAFER**

(30) Priority: 04.06.2013 JP 2013118096
(71) Applicant: Nippon Steel & Sumitomo Metal Corporation, Tokyo 100-8071 (JP)
(72) Inventor: AIGO, Takashi, Tokyo 100-8071 (JP); ITO, Wataru, Tokyo 100-8071 (JP); FUJIMOTO, Tatsuo, Tokyo 100-8071 (JP)
(74) Representative: Vossius & Partner Patentanwälte Rechtsanwälte mbB
(86) International application number: PCT/JP2014/063801
(87) International publication number: WO 2014/196394

(57) **Abstract**

Provided is a method for manufacturing an SiC single-crystal substrate making it possible to obtain an epitaxial SiC wafer provided with a high-quality SiC single-crystal thin film devoid of surface defects, etc. Also provided is said SiC single-crystal substrate. A method for manufacturing an SiC single-crystal substrate for an epitaxial SiC wafer having a high-quality SiC single-crystal thin film devoid of surface defects, etc., wherein the surface of the SiC single-crystal substrate is polished using chemical-mechanical polishing (CMP) at a speed of no more than 100 nm/h to remove the surface in a thickness of 100 nm or greater, and produce no more than 1 approximately circular pit per cm², the pit having a diameter of 0.5-1.5 µm and a depth of 50-500 nm.

## Description

### Technical Field

The present invention relates to a method for manufacturing a silicon carbide single-crystal substrate for an epitaxial silicon carbide wafer and to a silicon carbide single-crystal substrate for an epitaxial silicon carbide wafer.

### Background Art

Silicon carbide (below, indicated as "SiC") is excellent in heat resistance and mechanical strength and is physically and chemically stable, and so is focused on as an environmentally-resistant semiconductor material. Further, in recent years, demand for epitaxial SiC wafers has been rising as substrates for high frequency and high withstand voltage electronic devices.

When using an epitaxial SiC wafer to produce a power device, high frequency device, etc., in general, the thermal CVD method (thermal chemical vapor deposition method) is used two epitaxially grow an SiC thin film on an SiC single-crystal substrate (below, referred to as an "SiC substrate") and the ion implantation method is used to directly implant a dopant. In the latter case, after implantation, high temperature annealing becomes necessary, but formation of a thin film by epitaxial growth is a widely used technique.

Further, in general, to obtain an SiC substrate, an SiC single-crystal ingot is cut to a predetermined thickness using a wire saw etc., lapped to reduce the variation in thickness, and polished to reduce the damaged surface layer, then finally subjected to chemical mechanical polishing (CMP). Further, in some cases, this is further etched by gas to finish the SiC substrate (see PLTs 1 and 2).

In recent years, the development of SiC devices have been advanced at a fast pace. The need for handling larger current densities has been increasing. Due to this, the device areas have been increasing. As typical defects which are present at an epitaxial SiC wafer, there are triangular defects, carrot defects, and comet defects. Reduction of these as "device killer defects" has been strongly sought. At the present time, the density of these epitaxial defects is of the level of several defects to 10 or so defects or so per cm², but the number of epitaxial defects which are contained in a device has to be substantially zero. It is difficult to produce devices which have areas larger than 5 mm square or so with a high yield. To reduce the epitaxial defects, the growth temperature at the time of epitaxial growth, the ratio of the number of carbon atoms to the number of silicon atoms (C/Si ratio) in the material gases which flow at the time of growth, the treatment before growth, and various other conditions have been studied and optimized, but it is difficult to stably obtain a low epitaxial defect density of 1 to 2/cm² or less.

Therefore, application of the epitaxial SiC wafers to devices is further expected. However, because of the current densities of epitaxial defects, relatively small area devices can be made, but the epitaxial SiC wafers are difficult to be adapted to large sized devices which have areas not less than 5 mm square or so.

### Citation List

### Patent Literature

PLT 1: Japanese Patent Publication No. 2011-222750A (paragraph 0055)
PLT 2: Japanese Patent Publication No. 2013-34007A (paragraphs 0059 and 0072)

### Summary of Invention

### Technical Problem

The present invention provides a method for manufacturing a substrate for an epitaxial SiC wafer which enables realization of a high quality epitaxial film which is further reduced in carrot defects compared with the past in epitaxial growth using an SiC substrate and provides a substrate of the same.

### Solution to Problem

The inventors obtained the finding that, pits of a specific size among pits which start from the screw dislocations in the substrate and are formed on the substrate surface at the time of surface treatment of an SiC substrate become carrot defects by a ratio of about 100% when performing epitaxial growth. Further, the inventors discovered that formation of the pits is dependent on the polishing rate of the chemical mechanical polishing and the amount of material which is removed by the polishing and discovered that by suppressing predetermined pits, it is possible as a result to reduce the carrot defects of the epitaxial film and thereby reached the present invention. That is, the gist of the present invention is as follows:
(1) A method for manufacturing a silicon carbide single-crystal substrate for an epitaxial silicon carbide wafer comprising polishing a surface of a silicon carbide single-crystal substrate by a 10 nm/h to 100 nm/h at a polishing rate by chemical mechanical polishing to remove the surface of the silicon carbide single-crystal substrate to a thickness of 100 nm to 1000 nm in range.
(2) The method for manufacturing a silicon carbide single-crystal substrate for an epitaxial silicon carbide wafer according to (1) wherein the silicon carbide single-crystal substrate for an epitaxial silicon carbide wafer has approximately circular pits with a diameter of 0.5 µm to 1.5 µm and a depth of 50 nm to 500 nm of 1/cm² or less.
(3) The method for manufacturing a silicon carbide single-crystal substrate for an epitaxial silicon carbide wafer according to (1) or (2) further comprising performing reactive ion etching after surface polishing by the chemical mechanical polishing.
(4) The method for manufacturing a silicon carbide single-crystal substrate for an epitaxial silicon carbide wafer according to (3) wherein the gas which is used in the reactive ion etching is a noble gas.
(5) The method for manufacturing a silicon carbide single-crystal substrate for an epitaxial silicon carbide wafer according to any one of (1) to (4) wherein an off-angle of the silicon carbide single-crystal substrate is 4° or less.
(6) A silicon carbide single-crystal substrate for an epitaxial silicon carbide wafer comprised of a silicon carbide single-crystal substrate for an epitaxial silicon carbide wafer which is obtained by a method according to any one of (1) to (5) wherein approximately circular pits with a diameter of 0.5 µm to 1.5 µm and a depth of 50 nm to 500 nm are present in 1/cm² or less.

### Advantageous Effects of Invention

According to the present invention, it is possible to provide a silicon carbide single-crystal substrate for an epitaxial silicon carbide wafer which has device killer defects further reduced from the past and is excellent in surface flatness. According to the present invention, it is possible to obtain an SiC substrate which enables a high quality epitaxial SiC wafer which is particularly further reduced in carrot defects from the past at the epitaxial film on the SiC substrate. Further, the surface treatment of the present invention is the CMP method, so an SiC substrate for an epitaxial SiC wafer which is controlled in surface conditions with a good reproducibility is obtained. Furthermore, the epitaxial growth film which is grown using the SiC substrate for an epitaxial SiC wafer of the present invention is a high quality film which is reduced in carrot defects, so the characteristics and yield of the devices which are carried on it are improved.

### Brief Description of Drawings

FIG. 1 is a view which shows a typical growth sequence when performing epitaxial growth.
FIG. 2 is a photo of a carrot defect which is formed after epitaxial growth
FIG. 3 is a surface photo after CMP at the same location as FIG. 2 (before epitaxial growth)
FIG. 4 is an AFM image of an arrow part (start point of a carrot defect) of FIG. 3
FIG. 5 is a surface photo after etching an approximately circular part of FIG. 4 by molten KOH

### Description of Embodiments

Below, the present invention will be explained in detail. First, the treatment of the surface of the SiC substrate will be explained. In general, the surface treatment is comprised of shape control (lapping) of the wafer which is cut out from an ingot, reduction (polishing) of the damaged surface layer, and the final CMP.

Here, "CMP" is one of the polishing techniques which simultaneously gives the surface of a treated object a mechanical action and chemical action to obtain a surface which is free from a damaged surface layer. In the method according to "CMP", the chemicals in the slurry cause the formation of oxides at the surface and the oxides are simultaneously removed by polishing abrasives so as not to leave a damaged surface layer at the polished surface. As the slurry for CMP of an SiC substrate, there is a colloidal silica slurry in which hydrogen peroxide is included or slurry which is developed especially for SiC substrates (see Semiconductor SiC Technology and Applications, second edition, Nikkan Kogyo Shimbun). The particle size of the polishing abrasives, the amount of the polishing agent, the components and pH of the slurry, the treatment pressure at the time of CMP, the surface plate rotation, and other conditions are adjusted to determine the surface properties after processing. For the treatment time, usually the thickness of the damaged surface layer after polishing is 100 nm or so, therefore the polishing time is set so that this is removed and no polishing flaws remain.

The surface of above-mentioned SiC substrate that is obtained is subjected to epitaxial growth. The epitaxial growth will be explained below. The apparatus which is preferably used in the present invention for epitaxial growth is a horizontal type CVD apparatus. The CVD process is simple in hardware configuration and enables control of the thickness of epitaxial growth by turning the supply of gas on/off, so this is a growth process which is excellent in control and reproducibility of the epitaxial film.

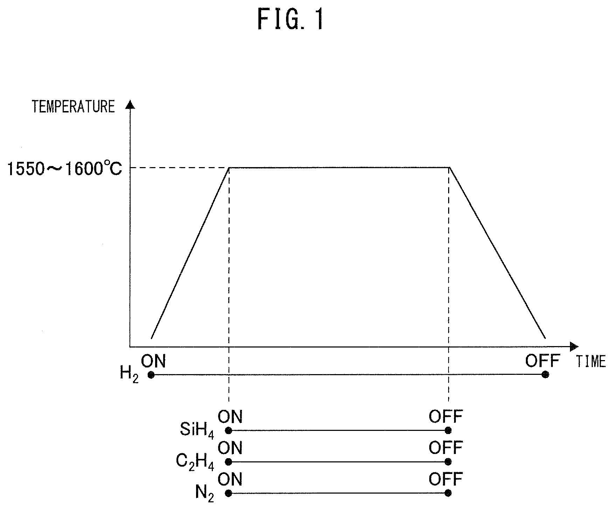

FIG. 1 shows together the typical growth sequence by the CVD process at the time of growing an epitaxial film together with the timing of introduction of gas. First, an SiC substrate is set in a growth furnace, the inside of the growth furnace is evacuated to a vacuum, then hydrogen gas is introduced to adjust the pressure to 1.0×10⁴ to 3×10⁴ Pa. After that, the pressure is held constant while raising the temperature of the growth furnace to 1550 to 1650°C that is growth temperature, then the material gases SiH₄ and C₂H₄ and the doping gas N₂ are introduced to start the growth. At this time, the flow rate of SiH₄ is made 40 to 50 cm³ per minute, the flow rate of C₂H₄ is made 20 to 40 cm³ per minute, and the speed of growth is made 6 to 7 µm per minute. Since the usually used epitaxial layer has a film thickness of 10 µm or so, the growth speed is determined considering the productivity. When the desired film thickness is obtained, the introduction of SiH₄, C₂H₄, and N₂ is stopped and only hydrogen gas is run. In that state, the temperature is lowered. After the temperature falls to ordinary temperature, the introduction of hydrogen gas is stopped, the inside of the growth chamber is evacuated to a vacuum, inert gas is introduced into the growth chamber, the growth chamber is returned to atmospheric pressure, then the SiC wafer is taken out.

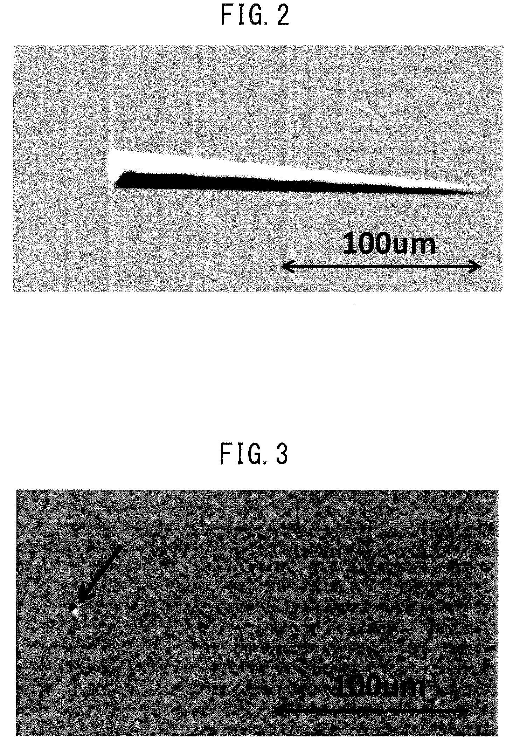

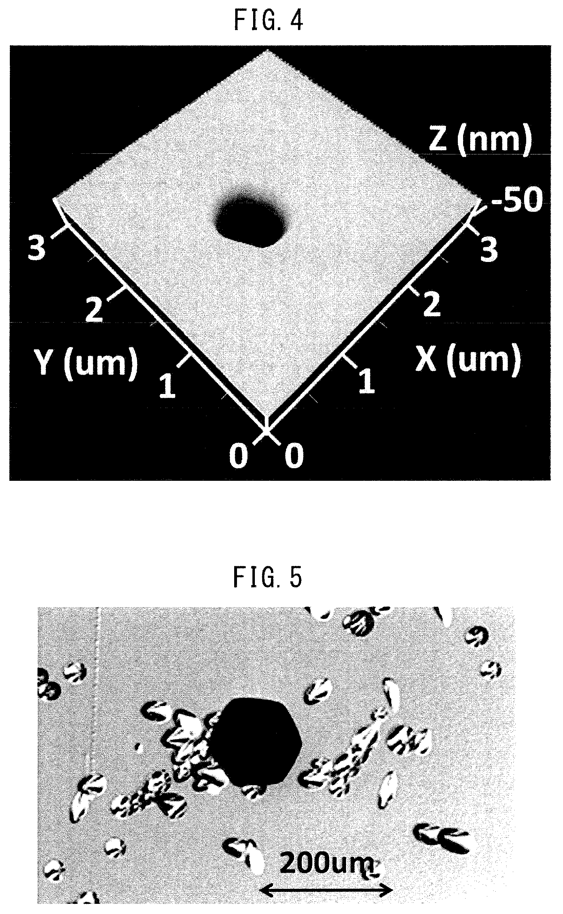

A photo of a carrot defect which is formed after epitaxial growth is shown in FIG. 2. Further, FIG. 3 shows a photo of the surface of an SiC substrate after CMP (before epitaxial growth) at the same location as the location shown in FIG. 2. In FIG. 3, the arrow part corresponds to the starting part of the carrot defect. An AFM image of this starting part is shown in FIG. 4. As will be understood from FIG. 4, an approximately circular pit with a diameter of about 0.5 to 1 µm is formed. The depth was about 70 nm. Further, a photo of the surface conditions after etching this approximately circular part by molten KOH is shown in FIG. 5. From FIG. 5, at the approximately circular part, a large hexagonal shaped etch pit appears. It will be understood that a screw dislocation which is present inside the SiC substrate corresponds to this. That is, it is clear that part of a screw dislocation which is present in the SiC substrate forms an approximately circular pit as explained above in the substrate surface due to CMP and that a carrot defect occurs starting from this.

As explained above, as the mechanism of CMP, it is believed that the polishing solution oxidizes the surface of the SiC substrate and the oxidized layer is removed by the polishing agent particles. However, at the screw dislocation parts, the crystallinity is disturbed, so the oxidation speed becomes faster than at other parts and as a result the amount which is removed by polishing becomes greater. As a result, it is believed that approximately circular pits are formed at the surface of the SiC substrate. Therefore, the inventors engaged in detailed studies whereupon they found the fact that when the approximately circular pits have a diameter of 0.5 µm to 1.5 µm and a depth of 50 nm to 500 nm, carrot defects occur by a probability of substantially 100% after epitaxial growth. The fact that carrot defects are formed by partial break-up of screw dislocations which are present in the SiC substrate at the time of epitaxial growth is known (see H. Tsuchida, M. Ito, I. Kamata, and M. Nagano: Phys. Status Solidi B 246, No. 7, 1553-1568 (2009)). It is believed that at the screw dislocation parts which are accompanied with the above such approximately circular pits, there are step differences at the surface and disturbances in the crystallinity, so the break-up occurs more easily and as a result carrot defects occur with a higher probability.

If the approximately circular pits which are formed at the surface of an SiC substrate have a diameter smaller than 0.5 µm and a depth shallower than 50 nm, the step differences at the surface will be small and the disturbances in the crystallinity will be small, so the probability of formation of carrot defects will become lower. Further, if the approximately circular pits have a diameter smaller than 0.5 µm and a depth deeper than 500 nm, it is believed that growth inside the pits will not advance, so the pits will remain substantially in their original form, but since they are small pits, the effect on the devices which are formed over them would be small. On the other hand, it is believed that if the approximately circular pits have a diameter larger than 1.5 µm, step flow growth from around the screw dislocations which cause the formation of pits becomes dominant, so the disturbance in crystallinity at the above screw dislocation parts is reversed, break-up of the screw dislocations becomes harder, and the formation of carrot defects is suppressed without regard as to the depth of the pits. That is, if an SiC substrate before epitaxial growth has approximately circular pits with a diameter of 0.5 µm to 1.5 µm and with a depth of 50 nm to 500 nm, the probability of formation of carrot defects at the epitaxial film will end up becoming high.

At general epitaxial films, currently the density of epitaxial defects, including various defects, is overall several defects to 10 defects per cm² in level, but among these, the density of triangular defects, comet defects, etc. is 1/cm² or so. Therefore, the majority are carrot defects. Among the carrot defects, there are also ones which occur due to normal screw dislocations which are not accompanied with morphological characteristics such as the above approximately circular pits, but the density of these is small, so unless reducing the density of the carrot defects which start from screw dislocations accompanied with these approximately circular pits, that is, the density of approximately circular pits itself, to 1/cm² or less in level, the overall defect density cannot be made 1 to 2/cm² or less. Note that, "approximately circular pits" include not only pits with shapes at the SiC substrate surface of true circles, but also pits which are not perfectly circular. When not perfect circles, the "pit diameter" shall mean the circle equivalent diameter.

Focusing on the density of approximately circular pits which have the above such sizes at the SiC substrate, the inventors studied the relationship of the CMP polishing rate and polishing amount, whereupon they found that if the polishing rate is 100 nm/h or less and the amount of polishing is 100 nm or more, the density of approximately circular pits is suppressed to 1/cm² or less. The CMP polishing rate is believed to be related to the processing pressure and the chemical activity etc. of the polishing solution. It is believed that the speed of oxidation at the screw dislocation parts and the number of screw dislocations which are reacted are varied by changing the polishing rate. Therefore, by adjusting the polishing rate, control of the shape and density of the approximately circular pits becomes possible. Further, the amount of polishing that should be removed by CMP, that is, the thickness of the damaged surface layer after polishing, is usually 50 to 100 nm or so. If the amount of removal is insufficient, control of the shape and density of the approximately circular pits will become difficult, so the damaged surface layer has to be sufficiently removed.

According to the present invention, an SiC substrate which is controlled in shape and density of approximately circular pits can be prepared. An epitaxial film with few defects which is grown on the SiC substrate can be obtained. However, in order to make the CMP substantially proceed, the polishing rate has to be made 10 nm/h or more. Here, if overly lowering the CMP polishing rate, a problem arises in the productivity, so the polishing rate is preferably made 50 nm/h to 100 nm/h, more preferably 50 nm/h to 80 nm/h. Further, regarding the amount of polishing by CMP, it is sufficient that the occurrence of carrot defects be suppressed. If considering the productivity, the upper limit of the amount of polishing is 1000 nm.

On the other hand, if the approximately circular pits can be made further smaller and shallower, the frequency of carrot defects which are formed there can be expected to become smaller. Therefore, after predetermined CMP treatment, it is effective to again treat the surface by reactive ion etching (below, referred to as "RIE"). However, in this case, it is possible that due to the reaction with the screw dislocation parts, etching will be locally promoted and conversely the pits will become larger and deeper in shape, so the gas which is used is desirably He, Ar, or another noble gas.

The epitaxial SiC wafer which is formed by using the SiC substrate which is obtained by the present invention can be used for various applications. In particular, by using an SiC substrate with an angle of inclination with respect to the (0001) plane of the SiC single-crystal in the <11-20> axial direction, defined as the "off-angle", of 4° or less, an epitaxial film which is reduced in defect density and also basal plane dislocation density is obtained, so this is suitable for devices in which high reliability is demanded or bipolar devices. In particular, as devices which are preferably formed on the obtained epitaxial SiC wafer, Schottky barrier diodes, PIN diodes, MOS diodes, MOS transistors, and other such devices which are used for power control may be mentioned.

### Examples

### Example 1

An SiC single-crystal ingot for a 4-inch (100 mm) wafer was sliced to about 400 µm thickness and polished by the usual method using lapping and diamond abrasives to prepare a substrate for CMP. The polytype of this substrate is 4H and this substrate has an off-angle of 4°. When performing polishing in this way, the thickness of the damaged surface layer at the surface was 100 nm or so or less. Next, CMP was performed as follows:
As the polishing slurry, one which contains silica or other polishing agent particles and acid was used. The polishing pressure and the pH of the slurry were suitably adjusted to make the polishing rate 100 nm/h so as to remove the surface of the substrate by a thickness of 100 nm (polishing amount: 100 nm) and prevent polishing flaws from remaining in the CMP. After the end of CMP, a confocal microscope (Laser Tech SICA61) was used to examine the pits at the surface of the SiC substrate which was obtained in this example and evaluate their shapes and depths, whereupon the density of approximately circular pits with a diameter of 0.5 µm to 1.5 µm and with a depth 50 nm to 500 nm in range was 0.8/cm².

Next, the obtained SiC substrate after CMP was subjected to epitaxial growth. As the procedure for this, the SiC substrate was set in a growth furnace, the inside of the growth furnace was evacuated to a vacuum, then hydrogen gas was introduced at 150 1/min while adjusting the pressure to 1.0×10⁴ Pa. After that, the pressure was held constant while raising the temperature of the growth furnace to 1600°C, the flow rate of SiH₄ was made 40 cm³ per minute, the flow rate of C₂H₄ was made 20 cm³ per minute, and the flow rate of N₂ for doping use was made 1 cm³ per minute to grow the epitaxial growth layer to a thickness of 10 µm. After growth, only hydrogen gas was run. In that state, the temperature was lowered. After falling to ordinary temperature, the introduction of hydrogen gas was stopped, the inside of the growth chamber was evacuated to a vacuum, inert gas was introduced into the growth chamber, the growth chamber was returned to atmospheric pressure, then the epitaxial SiC wafer was taken out.

The number of defects of the film which was epitaxially grown in this way was evaluated by the above confocal microscope, whereupon the carrot defect density was 1/cm². The carrot defect density is larger than the density of approximately circular pits because there are also, though slight, carrot defects which occur due to normal screw dislocations which are not accompanied with morphological characteristics. The density of epitaxial defects as a whole, including triangular defects and comet defects, was 1.8/cm².

### Example 2

Except for making the CMP polishing rate 80 nm/h and making the amount of polishing 100 nm, the same procedure as the procedure performed in Example 1 was followed to obtain the SiC substrate according to Example 2. At the surface of the SiC substrate after CMP, the density of approximately circular pits with a diameter of 0.5 µm to 1.5 µm and with a depth of 50 nm to 500 nm was 0.6/cm². Next, the same procedure as the procedure performed in Example 1 was followed to perform epitaxial growth and evaluate the number of defects of the epitaxial film after growth, whereby the carrot defect density was 0.8/cm², and the density of epitaxial defects as a whole, including triangular defects and comet defects, was 1.7/cm².

### Example 3

Except for making the CMP polishing rate 50 nm/h and making the amount of polishing 100 nm, the same procedure as the procedure performed in Example 1 was followed to obtain the SiC substrate according to Example 3. At the surface of the SiC substrate after CMP, the density of approximately circular pits with a diameter of 0.5 µm to 1.5 µm and with a depth of depth 50 nm to 500 nm was 0.4/cm². Next, the same procedure as the procedure performed in Example 1 was followed to perform epitaxial growth and evaluate the number of defects of the epitaxial film after growth, whereby the carrot defect density was 0.6/cm², and the density of epitaxial defects as a whole, including triangular defects and comet defects, was 1.4/cm².

### Example 4

Except for making the CMP polishing rate 30 nm/h and making the amount of polishing 100 nm, the same procedure as the procedure performed in Example 1 was followed to obtain the SiC substrate according to Example 4. At the surface of the SiC substrate after CMP, the density of approximately circular pits with a diameter of 0.5 µm to 1.5 µm and with a depth of depth 50 nm to 500 nm was 0.2/cm². Next, the same procedure as the procedure performed in Example 1 was followed to perform perform epitaxial growth and evaluate the number of defects of the epitaxial film after growth, whereby the carrot defect density was 0.5/cm², and the density of epitaxial defects as a whole, including triangular defects and comet defects, was 1.3/cm².

### Example 5

Except for the off-angle of the substrate subjected to the CMP being 2°, the same procedure as the procedure performed in Example 1 was followed to obtain the SiC substrate according to Example 5. At the surface of the SiC substrate after CMP, the density of approximately circular pits with a diameter of 0.5 µm to 1.5 µm and with a depth of depth 50 nm to 500 nm was 0.7/cm². Next, the same procedure as the procedure performed in Example 1 was followed to perform epitaxial growth and evaluate the number of defects of the epitaxial film after growth, whereby the carrot defect density was 1/cm², and the density of epitaxial defects as a whole, including triangular defects and comet defects, was 1.9/cm².

### Example 6

Except for the off-angle of the substrate subjected to the CMP being 0.5°, the same procedure as the procedure performed in Example 1 was followed to obtain the SiC substrate according to Example 6. At the surface of the SiC substrate after CMP, the density of approximately circular pits with a diameter of 0.5 µm to 1.5 µm and with a depth of depth 50 nm to 500 nm was 0.8/cm². Next, the same procedure as the procedure performed in Example 1 was followed to perform epitaxial growth and evaluate the number of defects of the epitaxial film after growth, whereby the carrot defect density was 1.1/cm², and the density of epitaxial defects as a whole, including triangular defects and comet defects, was 2/cm².

### Example 7

Up to the end of CMP, the same procedure as the procedure performed in Example 1 was followed to obtain the SiC substrate, then further an RIE apparatus was used to run Ar gas and etch the surface of the SiC substrate. As the conditions of the RIE (reactive ion etching), the etching pressure was 20 Pa, the Ar gas flow rate was 20 sccm, the high frequency power charged was 0.1W/cm², and a thickness of about 20 nm was etched.

The above obtained SiC substrate according to Example 7 had a density of approximately circular pits with a diameter of 0.5 µm to 1.5 µm and with a depth of depth 50 nm to 500 nm of 0.8/cm². The density of approximately circular pits is unchanged from Example 1, but when treating the thus obtained SiC substrate to perform epitaxial growth by the same procedure as in Example 1 and evaluate the number of defects of the epitaxial film after growth, the carrot defect density was 0.6/cm². This is believed to be because RIE caused the step differences and sizes of the approximately circular pits to be reduced and the disturbance in crystallinity of the pit parts to be eliminated, so and the probability that the pits become starting points of carrot defects was suppressed. Further, and the density of epitaxial defects as a whole, including triangular defects and comet defects, was 1.3/cm².

### Example 8

Up to the end of CMP, the same procedure as the procedure performed in Example 2 was followed to obtain the SiC substrate, then further an RIE apparatus was used to run He gas and etch the surface of the SiC substrate. As the conditions of the RIE, the etching pressure was 20 Pa, the He gas flow rate was 20 sccm, the high frequency power charged was 0.1W/cm², and a thickness of about 20 nm was etched.

The above obtained SiC substrate according to Example 8 had a density of approximately circular pits with a diameter of 0.5 µm to 1.5 µm and with a depth of depth 50 nm to 500 nm was 0.6/cm². The density of approximately circular pits is unchanged from Example 2, but when the thus obtained substrate was treated to perform epitaxial growth by the same procedure as the procedure performed in Example 1 and evaluate the number of defects of the epitaxial film after growth, the carrot defect density was 0.4/cm², and the density of epitaxial defects as a whole, including triangular defects and comet defects, was 1.1/cm².

### Example 9

Except for making the CMP polishing rate 100 nm/h and making the amount of polishing 500 nm, the same procedure as the procedure performed in Example 1 was followed to obtain the SiC substrate according to Example 9. At the surface of the SiC substrate after CMP, the density of approximately circular pits with a diameter of 0.5 µm to 1.5 µm and with a depth of depth 50 nm to 500 nm was 0.7/cm². Next, the same procedure as the procedure performed in Example 1 was followed to perform epitaxial growth and evaluate the number of defects of the epitaxial film after growth, whereby the carrot defect density was 0.9/cm², and the density of epitaxial defects as a whole, including triangular defects and comet defects, was 1.8/cm².

### Example 10

Except for making the CMP polishing rate 80 nm/h and the polishing amount 500 nm, the same procedure as the procedure performed in Example 1 was followed to obtain the SiC substrate according to Example 10. At the surface of the SiC substrate after CMP, the density of approximately circular pits with a diameter of 0.5 µm to 1.5 µm and with a depth of depth 50 nm to 500 nm was 0.6/cm². Next, the same procedure as the procedure performed in Example 1 was followed to perform epitaxial growth and evaluate the number of defects of the epitaxial film after growth, whereby the carrot defect density was 1.1/cm², and the density of epitaxial defects as a whole, including triangular defects and comet defects, was 1.7/cm².

### Comparative Example 1

Except for making the CMP polishing rate 150 nm/h and the polishing amount 100 nm, the same procedure as the procedure performed in Example 1 was followed to obtain the SiC substrate according to Comparative Example 1. At the surface of the SiC substrate after CMP, the density of approximately circular pits with a diameter of 0.5 µm to 1.5 µm and with a depth of depth 50 nm to 500 nm was 2.5/cm². Next, the same procedure as the procedure performed in Example 1 was followed to perform epitaxial growth and evaluate the number of defects of the epitaxial film after growth, whereby the carrot defect density was 2.8/cm², and the density of epitaxial defects as a whole, including triangular defects and comet defects, was 3.5/cm².

### Comparative Example 2

Except for making the CMP polishing rate 300 nm/h and the polishing amount 100 nm, the same procedure as the procedure performed in Example 1 was followed to obtain the SiC substrate according to Comparative Example 2. At the surface of the SiC substrate after CMP, the density of approximately circular pits with a diameter of 0.5 µm to 1.5 µm and with a depth of depth 50 nm to 500 nm was 4/cm². Next, the same procedure as the procedure performed in Example 1 was followed to perform epitaxial growth and evaluate the number of defects of the epitaxial film after growth, whereby the carrot defect density was 4.3/cm², and the density of epitaxial defects as a whole, including triangular defects and comet defects, was 5.2/cm².

### Comparative Example 3

Except for making the CMP polishing rate 500 nm/h and the polishing amount 500 nm, the same procedure as the procedure performed in Example 1 was followed to obtain the SiC substrate according to Comparative Example 3. At the surface of the SiC substrate after CMP, the density of approximately circular pits with a diameter of 0.5 µm to 1.5 µm and with a depth of depth 50 nm to 500 nm was 5.5/cm². Next, the same procedure as the procedure performed in Example 1 was followed to perform epitaxial growth and evaluate the number of defects of the epitaxial film after growth, whereby the carrot defect density was 5.8/cm², and the density of epitaxial defects as a whole, including triangular defects and comet defects, was 6.5/cm².

### Comparative Example 4

Except for making the CMP polishing rate 100 nm/h and the polishing amount 50 nm, the same procedure as the procedure performed in Example 1 was followed to obtain the SiC substrate according to Comparative Example 4. At the surface of the SiC substrate after CMP, the density of approximately circular pits with a diameter of 0.5 µm to 1.5 µm and with a depth of depth 50 nm to 500 nm was 2.1/cm² Even if the polishing rate was low, if the amount of polishing was small, the amount of removal of the damaged surface layer after polishing was insufficient, so the density of predetermined approximately circular pits was not reduced. Next, the same procedure as the procedure performed in Example 1 was followed to perform epitaxial growth and evaluate the number of defects of the epitaxial film after growth, whereby the carrot defect density was 2.5/cm², and the density of epitaxial defects as a whole, including triangular defects and comet defects, was 3.5/cm².

### Comparative Example 5

Except for making the CMP polishing rate 80 nm/h and the polishing amount 30 nm, the same procedure as the procedure performed in Example 1 was followed to obtain the SiC substrate according to Comparative Example 5. At the surface of the SiC substrate after CMP, the density of approximately circular pits with a diameter of 0.5 µm to 1.5 µm and with a depth of depth 50 nm to 500 nm was 2.7/cm². Even if the polishing rate was low, if the amount of polishing was small, the amount of removal of the damaged surface layer after polishing was insufficient, so the density of predetermined approximately circular pits was not reduced. Next, the same procedure as the procedure performed in Example 1 was followed to perform epitaxial growth and evaluate the number of defects of the epitaxial film after growth, whereby the carrot defect density was 3.2/cm², and the density of epitaxial defects as a whole, including triangular defects and comet defects, was 4.1/cm².

### Industrial Applicability

According to this invention, in epitaxial growth on an SiC substrate, it is possible to prepare an epitaxial SiC wafer which has a high quality epitaxial film which is reduced in epitaxial defects. Therefore, if forming electronic devices on such an epitaxial SiC wafer, the characteristics and yield of the devices can be expected to be improved.

## Claims

1. A method for manufacturing a silicon carbide single-crystal substrate for an epitaxial silicon carbide wafer comprising polishing a surface of a silicon carbide single-crystal substrate at a polishing rate of a 10 nm/h to 100 nm/h by chemical mechanical polishing to remove a thickness of 100 nm to 1000 nm in range from the surface of the silicon carbide single-crystal substrate.

2. The method for manufacturing a silicon carbide single-crystal substrate for an epitaxial silicon carbide wafer according to claim 1,
wherein said silicon carbide single-crystal substrate for an epitaxial silicon carbide wafer has approximately circular pits with a diameter of 0.5 µm to 1.5 µm and a depth of 50 nm to 500 nm of 1/cm² or less.

3. The method for manufacturing a silicon carbide single-crystal substrate for an epitaxial silicon carbide wafer according to claim 1 or 2,
further comprising performing reactive ion etching after surface polishing by said chemical mechanical polishing.

4. The method for manufacturing a silicon carbide single-crystal substrate for an epitaxial silicon carbide wafer according to claim 3,
wherein the gas which is used in said reactive ion etching is a noble gas.

5. The method for manufacturing a silicon carbide single-crystal substrate for an epitaxial silicon carbide wafer according to any one of claims 1 to 4,
wherein an off-angle of said silicon carbide single-crystal substrate is 4° or less.

6. A silicon carbide single-crystal substrate for an epitaxial silicon carbide wafer comprised of a silicon carbide single-crystal substrate for an epitaxial silicon carbide wafer which is obtained by a method according to any one of claims 1 to 5,
wherein approximately circular pits with a diameter of 0.5 µm to 1.5 µm and a depth of 50 nm to 500 nm are present in 1/cm² or less.
